# EUROPEAN PATENT SPECIFICATION

(11) **EP 2 031 644 B1**
(45) Date of publication and mention of the grant of the patent: **02.05.2018**
(21) Application number: 08163442.0
(22) Date of filing: 01.09.2008
(51) Int. Cl.: H01L 21/285

(54) **Method for improving germanide growth**
Verfahren zur Verbesserung des Germanidwachstums
Procédé pour améliorer la croissance de germaniure

(30) Priority: 31.08.2007 EP 07115482
(43) Date of publication of application: 04.03.2009
(73) Proprietor: IMEC VZW, 3001 Leuven (BE)
(72) Inventor: Brunco, David, San Mateo 94403 (US); Meuris, Marc, 3140 Keerbergen (BE)
(74) Representative: Vénite-Aurore, Olessia

(56) References cited:
- EP-A2- 1 763 084
- WO-A1-2006/011851
- US-A1- 2007 123 042
- ZHU SHIYANG ET AL: "Enhanced thermal stability of nickel germanide on thin epitaxial germanium by adding an ultrathin titanium layer", APPLIED PHYSICS LETTERS, AIP, AMERICAN INSTITUTE OF PHYSICS, MELVILLE, NY, US, vol. 91, no. 5, 31 July 2007 (2007-07-31), pages 51905-51905, XP012100326, ISSN: 0003-6951, DOI: 10.1063/1.2768203

## Description

### Field of the invention.

The present invention is related to the field of semiconductor processing and, more particularly, to the formation of low resistance layers on germanium substrates.

### Background of the invention.

Due to its electronic properties, germanium is considered to be a replacement for silicon as the semiconductor material of choice to form substrates and/or gate electrodes.

Germanides, e.g. compounds resulting from the reaction between germanium and a metal, such as Ni, are attractive for Ge based integrated circuits to reduce the resistivity of source and drain regions.

However, a fully manufacturable process for germanidation has yet to be developed.

Self-aligned germanides have already been described. Generally, such self-aligned germanides can be formed by depositing a layer of metal over a substrate and a germanium region, heating the structure to form a metal germanide and selectively removing unreacted metal, e.g. using a selective etching technique.

However, the methods that were available before the present invention result in several killer defects, including pits in the Ge and/or the formation of a conductive germanide excrescence (unwanted accretion) over areas intended for isolation. WO 2006/011851 discloses a method of preventing agglomeration of NiGe layers on S/D regions, comprising covering the Ni layer with a metal capping layer of Mo, Ta, Ti, W or Zr prior to annealing.

EP 1 763 084 discloses another method of preventing island formation in NiGe layers on S/D regions, comprising providing a TiN capping layer prior to annealing.

### Summary of the invention.

The present invention provides a method for preventing pits, overgrowth, or excrescences in the formation of a metal-germanide layer in a semiconductor device comprising the steps of:
- providing a substrate on which at least one area of a germanium layer is exposed, wherein, on said substrate, said Ge layer contacts another exposed material selected from the group consisting of a dielectric material, a metal such as TiN or TaN, a polymer capable of withstanding required process temperatures, and wherein said different exposed materials do not react with the metal used for germanidation,
- depositing over the substrate and said germanium area, any suitable metal, preferably Co or Ni,
- forming over said metal, a capping layer consisting of a silicon oxide containing layer, or of a silicon nitride layer, preferably of a SiO₂ layer,
- then annealing for metal-germanide formation,
- then removing selectively said capping layer, and
- then removing selectively the unreacted metal,
wherein the temperature used for said capping layer formation is lower than the annealing temperature.

Preferably, a method according to the invention further comprises, after removal of said unreacted metal, a second annealing step.

In a method of the invention, said germanium layer can be deposited (or formed) over the entire substrate (covering completely said substrate).

Alternatively, said germanium layer can be deposited (or formed) locally on the substrate, covering partially said substrate.

Preferably, said different exposed materials do not react with Ni when the metal used comprises (or consists) of Ni.

Preferably, said other exposed material is a dielectric material, more particularly, said other exposed material is SiO₂.

In a method of the invention, said dielectric material (other exposed material) can be used for or in the form of a field isolation region or a spacer.

Preferably, in a method of the invention, said annealing step(s) consist(s) of Rapid Thermal Process (RTP) step(s). Said annealing step(s) can be performed in a batch furnace, such as a horizontal or vertical diffusion furnace.

Said annealing step(s) can be performed in an inert ambient such as nitrogen.

Preferably, in a method of the invention, said capping layer is deposited by a CVD technique or by a spin-on deposition technique.

Preferably, in a method of the invention, a capping layer comprising, or consisting of, silicon nitride is deposited by a PECVD technique.

Preferably, said capping layer is less than (about) 100 nm thick, more preferably less than (about) 50 nm, more preferably less than (about) 20 nm, even more preferably less than (about) 15 nm, and even more preferably is about (about) 10 nm.

More particularly, said capping layer has a thickness comprised between (about) 1 nm and (about) 100 nm, preferably between (about) 2 nm and (about) 50 nm, more preferably between (about) 5 nm and (about) 20 nm, more preferably between (about) 7 nm and (about) 15 nm, even more preferably between (about) 10 nm and (about) 15 nm.

Preferably, in a method of the invention, said step of removing said capping layer is a wet process step.

Preferably, in a method of the invention, said step of removing the unreacted metal is a wet process step.

In a method of the invention, said step of removing said capping layer and said step of removing the unreacted metal can be performed simultaneously (in one step).

In a method of the invention, said metal can be any metal suitable for germanidation in a semiconductor device.

Preferably, said metal comprises nickel, cobalt, platinum, and/or palladium, and more preferably consists of nickel, cobalt, platinum, and/or palladium.

More preferably, in a method of the invention, said metal comprises Ni, more particularly comprises more than 90% Ni, and even more preferably said metal consists of Ni.

Preferably, in a method of the invention where said metal comprises (or more particularly consists of) nickel, the temperature used for said capping layer formation is lower than 300°C, preferably lower than 260°C, more preferably lower than 250°C, and even more preferably lower than 225°C.

Preferably, in a method of the invention where said metal comprises (or more particularly consists of) nickel, said annealing temperature(s) is/are higher than 300°C. More particularly said annealing temperature(s) is/are comprised between 300°C and 450°C, preferably between 325°C and 400°C, more preferably between 350°C and 400°C.

Preferably, in a method of the invention where said metal comprises (or more particularly consists of) nickel, a first annealing step is performed at a temperature comprised between 205°C and 325°C, more preferably between 210°C and 275°C, and even more preferably between 230°C and 270°C, and a second annealing step is performed at a temperature comprised between 300°C and 550°C, more preferably between 325°C and 400°C.

A method of the invention can be used for improving the metal-germanide layer properties.

A method of the invention can also be used for improving the metal-germanide layer formation, in particular its morphology, in a semiconductor device.

### Brief description of the drawings

Various embodiments are described herein with reference to the following drawings. Certain aspects of the drawings are depicted in a simplified way for reason of clarity. Not all alternatives and options are shown in the drawings and, therefore, the invention is not limited in scope to the content of the drawings. Like numerals are employed to reference like parts in the different figures.
Figure 1 shows a cross section of a germanium substrate (1), with an isolation structure (Box isolation) (2) and a Ni layer (3) deposited over said germanium substrate and said isolation structure. The circles (4, 5) define two different areas where the germanidation give different results in term of quality of the germanide layer obtained. The Box isolation is formed by depositing and patterning a SiO₂ layer on the substrate.
Figure 2 shows a Scanning Electron Microscope (SEM) picture of a nickel-germanide formed at 330°C, 30 sec (or at 360°C, 30 sec, or at 340°C, 35 sec), obtained according to a prior art process, exhibiting pits in the Ge layer, and germanide overgrowth on the Box isolation.
Figure 3 shows a SEM picture of a nickel-germanide formed at 330°C, 30 sec, obtained according to a method of the invention, with no defects (no pit, no overgrowth). Very similar results are obtained carrying out a method of the invention with a nickel-germanide formed at 340°C, 35 sec, or at 350°C, 30 sec.
Figures 4 is a flowchart illustrating a germanide-forming process according to the invention.

### Detailed description

The present invention is based on the surprising discovery that carrying out a method of the invention, comprising the formation of a SiO₂ capping layer on Ni and Ge layers before annealing and its selective removal, leaves a surface that is free of pits in the Ge layer and free of nickel-germanide overgrowth, and provides a nickel-germanide layer that exhibits a lower sheet resistance.

In the context of the present invention, the term "RTP step" is used in a generic sense, referring to semiconductor device processing, wherein the temperature is rapidly increased, e.g. involving heating rates higher than 10°C/s, and wherein the heating means include, but are not limited to, resistive wiring, halogen lamps, flash lamps, and lasers.

In the context of the present invention, the term "RTP tool" is also used in a generic sense, referring to any semiconductor process tool capable of rapid heating rates (e.g. higher than 10°C/s) including, but not limited to, systems heated by resistive wiring, halogen lamps, flash lamps, and lasers.

The present invention provides a method for preventing defects, such as pits, overgrowth, or excrescences, in the formation of a metal-germanide layer in a semiconductor device comprising the steps of:
- providing a substrate on which at least one area of a germanium layer is exposed,
- depositing over the substrate and said germanium area, any suitable metal, preferably Co or Ni,
- forming over said metal, a capping layer consisting of a silicon oxide containing layer, or of a silicon nitride layer, preferably a SiO₂ layer,
- then annealing for metal-germanide formation,
- then removing selectively said capping layer, and
- then removing selectively the unreacted metal,
wherein the temperature used for said capping layer formation is lower than the annealing temperature.

Said substrate can be any substrate with a Ge-based active layer, including bulk germanium wafers, germanium-on-insulator wafers, and deposited Ge layers on other substrates like silicon.

Preferably, said substrate comprises an exposed germanium area bordering (or contacting) a dielectric area.

The dielectric area may be a field isolation region or a spacer.

A height difference, or topographical step, may exist between the exposed surfaces of the germanium region and the dielectric region. The substrate can be a patterned wafer comprising germanium active areas separated by isolation regions. Said isolation regions, also referred to as field isolation regions, can be formed by one of several techniques such as box isolation or shallow-trench-isolation (STI).

Preferably, in case of box isolation, openings are formed, by dry or wet etch, in an oxide layer overlying a germanium layer to expose regions of this germanium layer. This way, SiO₂ isolation between germanium active areas can be obtained by depositing and patterning SiO₂ layers on the germanium surface.

Preferably, in the case of shallow-trench-isolation, grooves formed by dry-etch in the substrate are filled with a dielectric layer providing electrical insulation.

The germanium can be in an amorphous or crystalline state.

The germanium of the exposed region can comprise some amount of other materials suitable in semiconductor processing. More particularly, the germanium may comprise semiconductor materials such as silicon.

For instance, when the germanium region is formed by means of the germanium condensation technique, up to about 15% silicon can be present in the thus formed germanium layer.

The germanium may comprise (or may further comprise) dopants such as arsenic, phosphorus, antimony, boron, and gallium. The germanium may also comprise (or may also further comprise) other commonly used elements in semiconductor processing like carbon (C) and fluorine (F). The germanium may also comprise (or may also further comprise) nitrogen (N).

In a method of the invention, the germanium layer can be deposited (or formed) over the entire substrate (covering completely the substrate). Alternatively, the germanium layer can be deposited (or formed) locally on the substrate, covering partially the substrate.

The germanium active area can comprise one or more semiconductor devices.

If the semiconductor device is a field-effect-transistor, the germanium active area may comprise a stack of a gate electrode and a gate dielectric. This gate stack is formed on the germanium substrate, thereby, defining the channel region.

The gate dielectric can be an oxide, a nitrided oxide, an oxynitride, or a high-k dielectric (i.e. k > k(SiO₂)) such as a hafnium oxide or an aluminum oxide.

The gate electrode can be formed from a semiconductor material such as polysilicon, silicon-germanium, germanium, or from a metallic material such as TiN, TaN, and W.

The gate stack separates in a lateral direction the source electrode and the drain electrode, which contact at opposite lateral sides the channel region.

Against the gate stack, dielectric sidewall spacers can be formed to offset the source and drain regions from the channel region. These sidewall spacers can be formed for example from silicon-oxide, silicon-nitride, and/or silicon-carbide.

In a method of the invention, said metal layer is deposited over the substrate.

Preferably, the metal layer comprises (or consists of) any suitable metal, and more particularly nickel (Ni), or cobalt (Co).

Alloys of said metals can also be used in a method of the invention. Preferably, the alloys comprise about 50% or more of said metal.

Preferably, said metal comprises nickel, and in particular more than 50% nickel, preferably more than (about) 90% nickel. More preferably, the metal consists of nickel.

Said metal can comprise, or can further comprise, or can consist of platinum (Pt) and/or palladium (Pd). In particular, said metal can comprise (or consist of) platinum, palladium, and nickel. More particularly, said metal can comprise (or consist of) palladium and nickel, such as 90% nickel and 10% palladium.

The metal layer can be deposited using any layer deposition techniques known in the art, and more particularly chemical vapor deposition, or sputter deposition.

The thickness of the metal layer is selected to obtain, after completion of the germanide-forming process, a germanide layer with the desired metal/germanium ratio and the desired thickness.

In a method of the invention, said capping layer can consist of silicon oxide containing material, such as silicon oxynitride (SiON), referring herein to a material made of silicon, oxygen and nitrogen; carbonaceous silicon oxide (SiOC), referring herein to a material made of silicon, oxygen, and carbon; fluorinated silicon oxide (SiOF), referring herein to a material made of silicon, oxygen, and fluorine.

Preferably, said capping layer consists of a SiO₂ layer.

Alternatively, in a method of the invention, said capping layer can consist of a silicon nitride layer, referring herein to a material made of silicon and nitrogen. More particularly, said capping layer can consist of a Si₃N₄-like (also referred to as SiₓN_{y}, or also referred to as impure Si₃N₄) material, referring herein to a material made (essentially) of silicon and nitrogen, wherein x is different from 3 and y different from 4. Said capping can consist of Si₃N₄, but pure Si₃N₄ is more difficult to remove selectively than Si₃N₄-like material.

In a method of the invention, said capping layer is deposited at a temperature lower than the annealing temperature set for germanidation.

Said capping layer can be deposited by any suitable process known in the art, more particularly by a CVD process, or by a sputter deposition process.

Further examples of deposition techniques comprise Plasma Enhanced Chemical Vapor Deposition (PECVD), Atomic Layer CVD (also known as Atomic Layer Deposition), Atomic Vapor Deposition, or Metal Organic CVD (MOCVD).

These techniques also comprise Physical Vapor Deposition (PVD), further comprising sputtering, evaporation, molecular beam epitaxy (or deposition) (MBE), or jet vapor deposition.

These techniques also further comprise wet processes, such as spin-on deposition or electroplating.

Preferably, in a method of the invention, said capping layer is less than 100 nm thick, more preferably less than 50 nm, more preferably less than 20 nm, more preferably less than 15 nm, even more preferably is about 10 nm.

More particularly, in a method of the invention, said capping layer has a thickness comprised between 1 nm and 100 nm, preferably between 2 nm and 50 nm, even more preferably between 5 nm and 20 nm, even more preferably between 7 nm and 15 nm, and even more preferably between 10 nm and 15 nm.

Preferably, said annealing step(s) (for germanidation) is/are performed in a thermal processing tool, e.g. as an RTP tool or a batch furnace, such as a horizontal or vertical diffusion furnace. More preferably, said annealing step(s) is/are performed in an RTP tool.

In a method of the invention, said capping layer can be selectively removed by any suitable techniques known in the art.

Preferably, said capping layer is selectively removed by wet etching, in particular using a composition comprising hydrofluoric acid (HF), more particularly using a dilute solution of HF (e.g. 0.03 M HF solution).

In a method of the invention, if SiO₂ is used as capping layer, the selective removal can be performed using a composition comprising hydrofluoric acid (HF), preferably diluted with water, preferably with an HF concentration of 0.03 to 2 vol.%. Buffering agents, such as ammonium fluoride (NH₄F), may also be added.

In a method of the invention, the metal selective removal step can be performed by any suitable techniques known in the art.

Conditions for the metal selective removal step depend upon the deposited metal and the other materials present on the substrate.

D. Brunco et al discloses in "Germanium MOSFET Devices: Advances in Material Understanding, Process Development, and Electrical Performance" published in Journal of Electrochemical Society 155(7) H552-H561 (2008), in table I the etch speed of germanium for various etch chemistries. Chemistries for the selective removal of the cap and unreacted metal preferably have zero to low (< 1 nm/min) etch rates of germanium.

Preferably, said metal is selectively removed by wet etching.

For instance, said metal can be selectively removed using a composition comprising an aqueous solution of at least one hydrohalide selected from the group consisting of HF, HCl, HBr, and HI. Said composition can further comprise a solution of H₂SO₄, and/or a solution of NH₄OH, and/or a solution of H₃PO₄.

Said composition can further comprise a solution of HNO₃. In particular, said composition can comprise HCl and HNO₃.

In particular said metal can be selectively removed using a composition comprising hydrochloric acid (HCl), more particularly using a dilute solution of HCl (e.g. 10 vol% HCl solution, at 55°C).

A method of the invention can comprise a second annealing step, after the selective removal of the metal.

In that case, the first annealing temperature is preferably comprised between 200°C and 400°C, preferably between 200°C and 325°C, e.g. for a time period in the range of nearly 0 seconds (e.g. 1 millisecond) to 300 seconds, preferably in the range of 10 seconds to 60 seconds.

Preferably, the temperature of said first thermal step (or first annealing temperature) is in the range of 205°C to 325°C. More preferably, the temperature of said first thermal step is in the range of 210°C to 275°C. Even more preferably, the temperature of said first thermal step is in the range of 230°C to 270°C.

The temperature of the second thermal step (or second annealing temperature) is in the range of 280°C to 550°C, e.g. for a time period of less than 600 seconds, preferably comprised between 1 millisecond and 300 seconds.

More preferably, the second annealing temperature is in the range of 300°C to 550°C, whereby the resistance of the germanide layer is reduced to meet required specifications. Even more preferably, the second annealing temperature is in the range of 325°C to 400°C.

According to a preferred method of the invention, Ni is the metal used.

In said preferred method of the invention, the temperature of the capping layer deposition is lower than 300°C, preferably lower than 250°C, and even more preferably lower than 225°C.

In said preferred method of the invention, the temperature of the annealing step(s) is higher than 300°C. Preferably, the temperature of said annealing step(s) is comprised between 300°C and 550°C, more preferably comprised between 325°C and 400°C, or even more preferably comprised between 350°C and 400°C.

Preferably, said temperature is reached and maintained for a total time period of less than 600 seconds, preferably comprised between 1 millisecond and 300 seconds.

Alternatively, said preferred method of the invention can comprise a first annealing step (between the step of forming, over Ni, said capping layer and the step of removing selectively said capping layer) and a second annealing step (after the step of selectively removing said unreacted Ni).

Said first annealing step is preferably performed at a temperature comprised between 205°C and 400°C, more preferably between 250°C and 350°C, and even more preferably between 270°C and 330°C.

Said second annealing step is preferably performed at a temperature comprised between 300°C and 550°C, more preferably between 325°C and 400°C.

The deposition of said capping layer may involve a temperature that allows the conversion of said Ni into a nickel-germanide to begin (between about 250° and 300°C). Thus, the nickel-germanide formed during the deposition of said capping layer would comprise nickel-rich germanide phases, in particular Ni₅Ge₃. In that case, the annealing step completes the reaction, preferably such that the germanide phase is essentially a mono nickel-germanide phase (NiGe). In such a case, still the capping layer plays a protecting role, resulting in a device free of defects.

The Ni can be removed selectively by any suitable techniques known in the art.

For instance, a composition comprising nitric acid (HNO₃), sulfuric acid (H₂SO₄), and water (H₂O) can be used, at room temperature. The concentration by volume of the nitric acid may be 0.1%, the concentration by volume of the sulfuric acid may be 52.9%, and the concentration by volume of the water may be 47%.

Preferably, said Ni is selectively removed by wet etching, in particular using a composition comprising hydrochloric acid (HCl), more particularly using a dilute solution of HCl (e.g. 10 vol% HCl solution, at 55°C).

According to a more preferred method of the invention, Ni is the metal used and the capping layer consists of SiO₂.

Said SiO₂ capping layer can be selectively removed by any suitable techniques known in the art.

Preferably, said SiO₂ capping layer is selectively removed by wet etching, in particular using a composition comprising hydrofluoric acid (HF), more particularly using a dilute solution of HF (e.g. 0.03 M HF solution).

In said more preferred method of the invention, the unreacted nickel and the SiO₂ capping layer can be selectively removed in one step. More particularly, said unreacted nickel and said SiO₂ capping layer can be removed using a composition comprising both HCl and HF. Preferably, the removal of the unreacted nickel and the removal of the SiO₂ capping layer are sequential, using respectively a dilute HF solution for SiO₂ removal and a dilute HCl solution for nickel removal.

Carrying out a method of the invention results in a substrate, also object of the invention, comprising a metal-germanide formed on a germanium area bordering a dielectric region (2, 4), wherein (essentially) no pits are present in the germanium area near the germanium-dielectric region (4) and (essentially) no undesirable germanide is present on the dielectric region (2, 4).

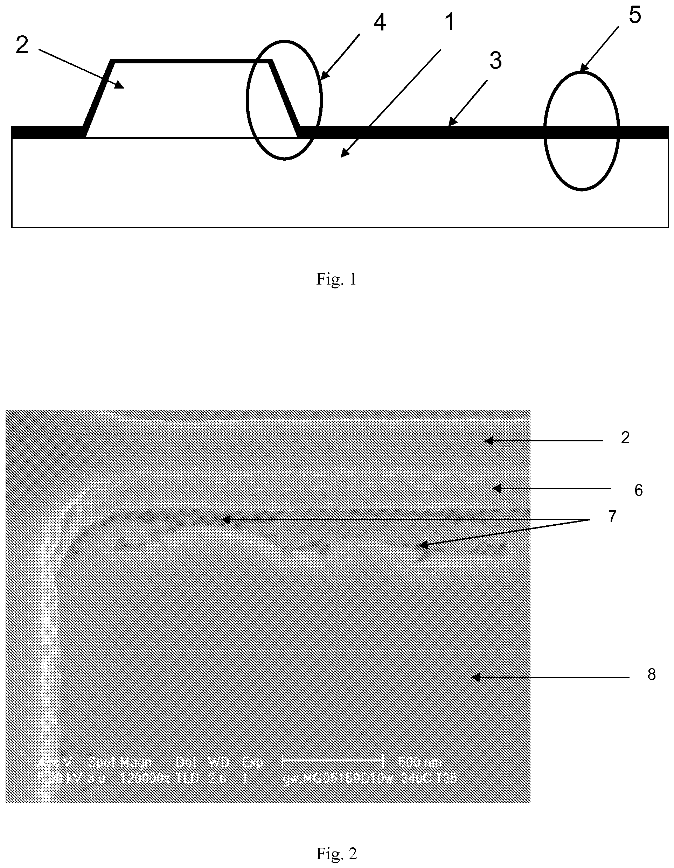

In Figure 1, a cross-section is shown of a germanium substrate (1), an isolation region (2) and a metal layer (3), with the indication of the bordering region (4), illustrating a method of the invention before the deposition of the capping layer. The region (5) is remote from the Box isolation.

Figure 2 shows a Scanning Electron Microscope (SEM) picture of a nickel-germanide layer formed on a patterned substrate, according to a prior art method.

About 10 nm of nickel was deposited on a substrate containing exposed germanium surfaces, bordering a dielectric region.

This substrate was heated to about 360°C for about 30 sec. Unreacted nickel was selectively wet etched from the substrate. A very similar result is obtained when heated to about 340°C for about 35 sec.

This picture was taken from the germanided surface of the substrate, which was tilted to 35°. This picture clearly shows the pits (7) created in the active area (8), near the isolation region (2). Besides the pits (7), germanide overgrowth (6) can be observed on the isolation.

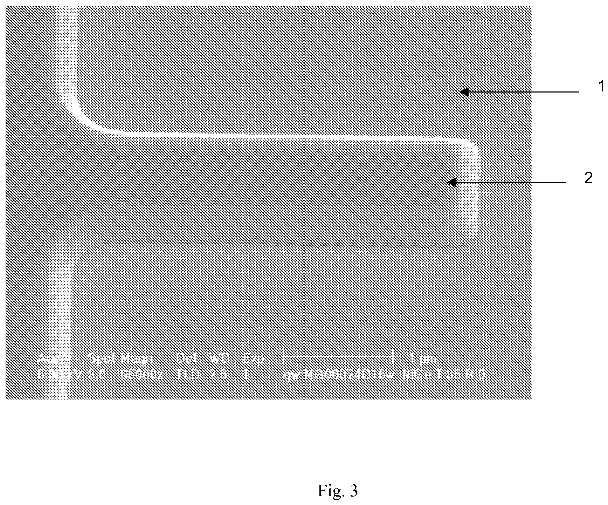

Figure 3 shows a Scanning Electron Microscope (SEM) picture of a nickel-germanide layer formed on a patterned substrate, after having carried out a method of the invention (see example 2).

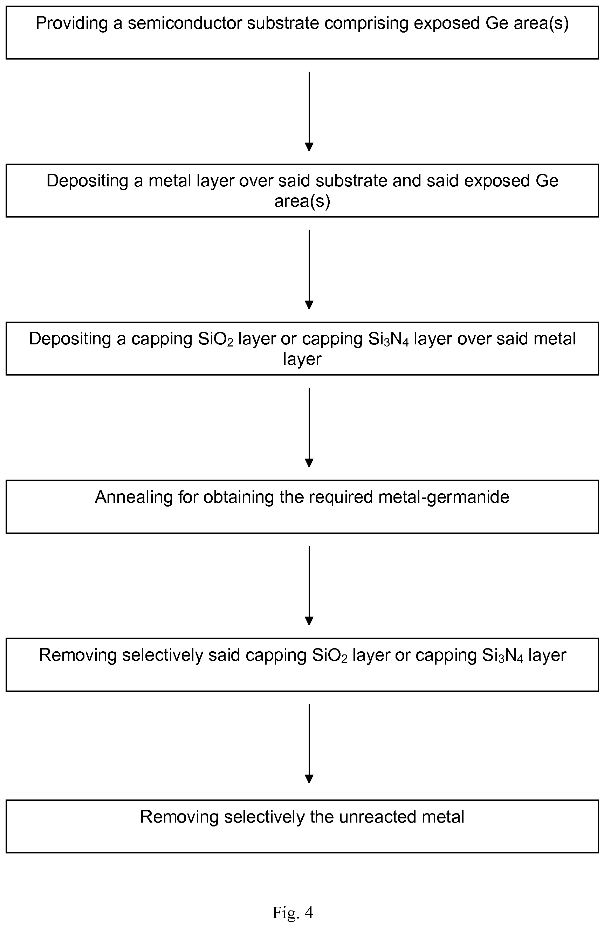

Figure 4 is a flowchart illustrating a process for forming a germanide layer according to the invention.

### EXAMPLES

### Example 1.

Epitaxial Ge layers are grown on Si wafers (using an ASM® epitaxial reactor).

A 10 nm thick Ni layer is deposited over the Ge layer.

A 10 nm thick SiO₂ capping layer is formed at 250°C.

The unreacted Ni and the SiO₂ capping layer are removed by dipping in a bath consisting of a mixture of dilute HCl solution and dilute HF solution.

All anneals are performed in AST® tool.

With an annealing temperature of 330°C, the SiO₂ capping layer suppresses Ge pits and overgrowth on the Box isolation. Moreover, the resistance sheet measured is lower than the one measured without the SiO₂ capping layer.

A similar result is observed when applying an annealing temperature of 350°C.

### Example 2.

Epitaxial Ge layers are grown on Si wafers (using an ASM® epitaxial reactor).

A 10 nm thick Ni layer is deposited over the Ge layer.

A 10 nm thick or a 20 nm thick SiO₂ capping layer is formed either at 200°C or at 250°C.

The unreacted Ni and the SiO₂ capping layer are removed by dipping in a bath consisting of a mixture of dilute HCl solution and dilute HF solution.

All anneals are performed in AST® tool at a temperature of 330°C.

When compared with the sample obtained without SiO₂ capping layer, the samples with the SiO₂ capping layer have almost no defect and exhibit a much lower resistance sheet.

### Example 3.

Epitaxial Ge layers are grown on Si wafers (using an ASM® epitaxial reactor).

In this example, the epitaxial germanium layer is relaxed (or unstrained) and about 1.7 µm thick.

Isolation regions are formed by depositing and patterning a silicon oxide layer on a germanium surface thereby forming of a patterned layer of 250 nm thick SiO₂.

A cleaning step is performed consisting of a water rinse, which dissolves germanium oxides.

A 10 nm thick Ni layer is deposited over the Ge layer.

Said Ni layer is deposited by Physical Vapor Deposition (PVD), also known as sputtering.

A 10 nm thick SiO₂ capping layer is formed at 250°C.

Said SiO₂ capping layer is formed using Plasma Enhanced Chemical Vapor Deposition (PECVD) with SiH₄ and N₂O precursors.

The unreacted Ni and the SiO₂ capping layer are removed by dipping in a bath consisting of a mixture of dilute HCl solution and dilute HF solution.

All anneals are performed in AST® RTP tool.

With an annealing temperature of 330°C, the SiO₂ capping layer suppresses Ge pits and overgrowth on the isolation region (2). Moreover, the resistance sheet measured is lower than the one measured without the SiO₂ capping layer.

A similar result is observed (for topography and sheet resistance) when applying an annealing temperature of 340°C, or 350°C for about 30 sec.

### Example 4.

Epitaxial Ge layers are grown on Si wafers (using an ASM® epitaxial reactor).

In this example, the epitaxial germanium layer is relaxed (or unstrained) and about 1.7 µm thick.

Isolation regions are formed by depositing and patterning a silicon oxide layer on a germanium surface thereby forming of a patterned layer of 250 nm thick SiO₂.

A cleaning step is performed consisting of a water rinse, which dissolves germanium oxides.

A 10 nm thick Ni layer is deposited by over the Ge layer.

Said Ni layer is deposited by PVD.

A 10 nm thick or a 20 nm thick SiO₂ capping layer is formed either at 200°C or at 250°C.

Said SiO₂ capping layer is formed using PECVD.

The unreacted Ni and the SiO₂ capping layer are removed by dipping in a bath consisting of a mixture of dilute HCl solution and dilute HF solution.

All anneals are performed in AST® RTP tool at a temperature of 330°C.

When compared with the sample obtained without SiO₂ capping layer, the samples with the SiO₂ capping layer have almost no defect and exhibit an equivalent or a lower sheet resistance.

## Claims

1. A method for preventing pits, overgrowth, or excrescences, in the formation of a metal-germanide layer in a semiconductor device comprising the steps of:
- providing a substrate on which at least one area of a germanium layer is exposed, wherein, on said substrate, said Ge layer contacts another exposed material selected from the group consisting of a dielectric material, a metal such as TiN or TaN, a polymer capable of withstanding required process temperatures, and wherein said different exposed materials do not react with the metal used for germanidation,
- depositing over the substrate and said germanium area, any suitable metal,
- forming over said metal, a capping layer consisting of a silicon oxide containing layer, or of a silicon nitride layer,
- then annealing for metal-germanide formation,
- then removing selectively said capping layer, and
- then removing selectively the unreacted metal,
wherein the temperature used for said capping layer formation is lower than the annealing temperature.

2. A method according to claim 1 further comprising a second annealing step after removal of said unreacted metal.

3. A method according to claim 1 or 2, wherein said other exposed materials do not react with Ni when said metal comprises or consists of Ni.

4. A method according to claim 3, wherein said other exposed material is a dielectric material.

5. A method according to claim 3 or 4, wherein said other exposed material is SiO₂.

6. A method according to claim 4 or 5, wherein said dielectric material is used for or in the form of a field isolation region or a spacer.

7. A method according to any of claims 1 to 6, wherein said annealing step(s) consist(s) of Rapid Thermal Process (RTP) step (s) .

8. A method according to any of claims 1 to 7, wherein said annealing step(s) is/are performed in a batch furnace, such as a horizontal or vertical diffusion furnace.

9. A method according to claim 7 or 8, wherein said annealing step(s) is/are performed in an inert ambient such as nitrogen.

10. A method according to any of claims 1 to 9, wherein said capping layer is deposited by a CVD technique or by a spin-on deposition technique.

11. A method according to any of claims 1 to 10, wherein said silicon nitride capping layer is deposited by a PECVD technique.

12. A method according to any of claims 1 to 11, wherein said capping layer is less than 100 nm thick.

13. A method according to any of claims 1 to 12, wherein said step of removing said capping layer is a wet process step.

14. A method according to any of claims 1 to 13, wherein said step of removing the unreacted metal is a wet process step.

15. A method according to any of claims 1 to 14, wherein said step of removing said capping layer and wherein said step of removing the unreacted metal are performed simultaneously.

16. A method according to any of claims 1 to 15, wherein said metal for germanidation comprises Ni.

17. A method according to any of claims 1 to 15, wherein said metal for germanidation consists of Ni.

18. A method according to any of claims 1 to 15, wherein said metal for germanidation comprises nickel, cobalt, platinum, and/or palladium.

19. A method according to claim 16, wherein said metal comprises 90% nickel and 10% palladium.

20. A method according to claim 17, wherein the temperature used for said capping layer formation is lower than 300°C.

21. A method according to claim 17 or 20 wherein said annealing temperature(s) is/are higher than 300°C.

22. A method according to claim 17 or 20 wherein said annealing temperature(s) is/are comprised between 300°C and 450°C.

## Patentansprüche

1. Verfahren zur Verhinderung von Gruben, Überwachsung, oder Auswüchsen bei der Bildung einer Metall-Germanid-Schicht in einer Halbleitervorrichtung, die folgenden Schritte umfassend :
- Bereitstellen eines Substrats, auf dem mindestens ein Bereich einer Germaniumschicht freigelegt ist, wobei, auf dem Substrat, die Ge-Schicht in Kontakt mit einem weiteren ausgesetzten Material ist, ausgewählt aus der Gruppe, bestehend aus einem dielektrischen Material, einem Metall wie z. B. TiN oder TaN, einem Polymer, das dazu in der Lage ist, den erfoderlichen Verfahrenstemperaturen standzuhalten, und wobei die verschiedenen ausgesetzten Materialien nicht mit dem Metall reagieren, das zur Germanidierung verwendet wird
- Ablegen über dem Substrat und dem Germaniumbereich eines geeigneten Metalls,
- Bilden über dem Metall einer Abdeckschicht, bestehend aus einer Siliziumoxid-enthaltenden Schicht, oder aus einer Siliziumnitridschicht,
- dann Glühen zur Metall-Germanid-Bildung,
- dann selektives Entfernen der Abdeckschicht, und
- dann selektives Entfernen des nicht reagierten Metalls,
wobei die Temperatur, die für die Bildung der Abdeckschicht verwendet wird, geringer als die Glühtemperatur ist.

2. Verfahren nach Anspruch 1, weiter umfassend einen zweiten Schritt des Glühens nach der Entfernung des nicht reagierten Metalls.

3. Verfahren nach Anspruch 1 oder 2, wobei die anderen ausgesetzten Materialien nicht mit Ni reagieren, wenn das Metall Ni umfasst oder daraus besteht.

4. Verfahren nach Anspruch 3, wobei das andere ausgesetzte Material ein dielektrisches Material ist.

5. Verfahren nach Anspruch 3 oder 4, wobei das andere ausgesetzte Material SiO₂ ist.

6. Verfahren nach Anspruch 4 oder 5, wobei das dielektrische Material verwendet wird für oder in der Form einer Feldisolierungsregion oder eines Abstandhalters.

7. Verfahren nach einem der Ansprüche 1 bis 6, wobei der/die Schritt(e) des Glühens aus (einem) Rapid Thermal Process (RTP)-Schritt(en) besteht/bestehen.

8. Verfahren nach einem der Ansprüche 1 bis 7, wobei der/die Schritt(e) des Glühens in einem Kammerofen wie z. B. in einem horizontalen oder vertikalen Diffusionsofen durchgeführt wird/werden.

9. Verfahren nach Anspruch 7 oder 8, wobei der/die Schritt(e) des Glühens in einer inerten Umgebung wie z. B. Stickstoff durchgeführt wird/werden.

10. Verfahren nach einem der Ansprüche 1 bis 9, wobei die Abdeckschicht durch eine CVD-Technik oder durch eine Aufschleudertechnik abgelegt wird.

11. Verfahren nach einem der Ansprüche 1 bis 10, wobei die Siliziumnitrid-Abdeckschicht durch eine PECVD-Technik abgelegt wird.

12. Verfahren nach einem der Ansprüche 1 bis 11, wobei die Abdeckschicht weniger als 100 nm dick ist.

13. Verfahren nach einem der Ansprüche 1 bis 12, wobei der Schritt des Entfernens der Abdeckschicht ein nasser Verfahrensschritt ist.

14. Verfahren nach einem der Ansprüche 1 bis 13, wobei der Schritt des Entfernens des nicht reagierten Metalls ein nasser Verfahrensschritt ist.

15. Verfahren nach einem der Ansprüche 1 bis 14, wobei der Schritt des Entfernens der Abdeckschicht und wobei der Schritt des Entfernens des nicht reagierten Metalls gleichzeitig durchgeführt werden.

16. Verfahren nach einem der Ansprüche 1 bis 15, wobei das Metall zur Germanidierung Ni umfasst.

17. Verfahren nach einem der Ansprüche 1 bis 15, wobei das Metall zur Germanidierung aus Ni besteht.

18. Verfahren nach einem der Ansprüche 1 bis 15, wobei das Metall zur Germanidierung Nickel, Kobalt, Platin, und/oder Palladium umfasst.

19. Verfahren nach Anspruch 16, wobei das Metall 90 % Nickel und 10 % Palladium umfasst.

20. Verfahren nach Anspruch 17, wobei die Temperatur, die für die Bildung der Abdeckschicht verwendet wird, geringer als 300 °C ist.

21. Verfahren nach Anspruch 17 oder 20, wobei die Glühtemperatur(en) höher als 300 °C ist/sind.

22. Verfahren nach Anspruch 17 oder 20, wobei die Glühtemperatur(en) im Bereich zwischen 300 °C und 450 °C liegen.

## Revendications

1. Procédé pour la prévention de puits, de surcroissance, ou d'excroissances, dans la formation d'une couche de germaniure métallique dans un dispositif à semiconducteur, comprenant les étapes de :
- fourniture d'un substrat sur lequel au moins une zone d'une couche de germanium est exposée, dans lequel, sur ledit substrat, ladite couche de Ge est en contact avec un autre matériau exposé choisi dans le groupe consistant en un matériau diélectrique, un métal tel que TiN ou TaN, un polymère capable de résister à des températures de traitement requises, et dans lequel lesdits différents matériaux exposés ne réagissent pas avec le métal utilisé pour la germaniurisation,
- dépôt, sur le substrat et ladite zone de germanium, d'un quelconque métal adapté,
- formation, sur ledit métal, d'une couche de recouvrement consistant en une couche contenant de l'oxyde de silicium, ou en une couche de nitrure de silicium,
- ensuite, recuit pour former le germaniure métallique,
- ensuite, élimination sélective de ladite couche de recouvrement, et
- ensuite, élimination sélective du métal n'ayant pas réagi,
dans lequel la température utilisée pour former ladite couche de recouvrement est inférieure à la température de recuit.

2. Procédé selon la revendication 1, comprenant en outre une seconde étape de recuit après l'élimination dudit métal n'ayant pas réagi.

3. Procédé selon la revendication 1 ou 2, dans lequel lesdits autres matériaux exposés ne réagissent pas avec le Ni lorsque ledit métal comprend ou consiste en du Ni.

4. Procédé selon la revendication 3, dans lequel ledit autre matériau exposé est un matériau diélectrique.

5. Procédé selon la revendication 3 ou 4, dans lequel ledit autre matériau exposé est SiO₂.

6. Procédé selon la revendication 4 ou 5, dans lequel ledit matériau diélectrique est utilisé pour ou sous la forme d'une région d'isolement de champ ou d'un élément d'espacement.

7. Procédé selon l'une quelconque des revendications 1 à 6, dans lequel ladite ou lesdites étapes de recuit consistent en une ou plusieurs étapes de traitement thermique rapide (RTP).

8. Procédé selon l'une quelconque des revendications 1 à 7, dans lequel ladite ou lesdites étapes de recuit sont effectuées dans un four discontinu, tel qu'un four à diffusion horizontale ou verticale.

9. Procédé selon la revendication 7 ou 8, dans lequel dans lequel ladite ou lesdites étapes de recuit sont effectuées dans un milieu ambiant inerte tel que l'azote.

10. Procédé selon l'une quelconque des revendications 1 à 9, dans lequel ladite couche de recouvrement est déposée par une technique de dépôt chimique en phase vapeur (CVD) ou par une technique de dépôt par rotation.

11. Procédé selon l'une quelconque des revendications 1 à 10, dans lequel ladite couche de recouvrement de nitrure de silicium est déposée par une technique de dépôt chimique en phase vapeur activé par plasma (PECVD).

12. Procédé selon l'une quelconque des revendications 1 à 11, dans lequel ladite couche de recouvrement a une épaisseur inférieure à 100 nm.

13. Procédé selon l'une quelconque des revendications 1 à 12, dans lequel ladite étape d'élimination de ladite couche de recouvrement est une étape de traitement par voie humide.

14. Procédé selon l'une quelconque des revendications 1 à 13, dans lequel ladite étape d'élimination du métal n'ayant pas réagi est une étape de traitement par voie humide.

15. Procédé selon l'une quelconque des revendications 1 à 14, dans lequel ladite étape d'élimination de ladite couche de recouvrement et ladite étape d'élimination du métal n'ayant pas réagi sont effectuées simultanément.

16. Procédé selon l'une quelconque des revendications 1 à 15, dans lequel ledit métal de germaniurisation comprend du Ni.

17. Procédé selon l'une quelconque des revendications 1 à 15, dans lequel ledit métal de germaniurisation consiste en du Ni.

18. Procédé selon l'une quelconque des revendications 1 à 15, dans lequel ledit métal de germaniurisation comprend du nickel, du cobalt, du platine, et/ou du palladium.

19. Procédé selon la revendication 16, dans lequel ledit métal comprend 90 % de nickel et 10 % de palladium.

20. Procédé selon la revendication 17, dans lequel la température utilisée pour former ladite couche de recouvrement est inférieure à 300°C.

21. Procédé selon la revendication 17 ou 20, dans lequel ladite ou lesdites températures de recuit sont supérieures à 300°C.

22. Procédé selon la revendication 17 ou 20, dans lequel ladite ou lesdites températures de recuit sont comprises entre 300°C et 450°C.
